(19) Europäisches Patentamt
European Patent Office
Office européen des brevets

(11) **EP 2 575 003 B1**

## (12) EUROPEAN PATENT SPECIFICATION

(45) Date of publication and mention
of the grant of the patent:
**14.05.2014 Bulletin 2014/20**

(51) Int Cl.:
***G06F 1/20*** *(2006.01)*

(21) Application number: **12180752.3**

(22) Date of filing: **16.08.2012**

(54) **Method for determining assignment of loads of data center and information processing system**

Verfahren zur Bestimmung der Lastzuweisung eines Datenzentrums und Informationsverarbeitungssystem

Procédé pour déterminer l'attribution de charges de centre de données et système de traitement d'informations

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.09.2011 JP 2011211789**

(43) Date of publication of application:
**03.04.2013 Bulletin 2013/14**

(73) Proprietor: **Hitachi, Ltd.**
**Tokyo 100-8280 (JP)**

(72) Inventor: **Shimizu, Hayato**
**Tokyo, 100-8220 (JP)**

(74) Representative: **Beetz & Partner**
**Patentanwälte**
**Steinsdorfstraße 10**
**80538 München (DE)**

(56) References cited:
**WO-A1-2011/046067        WO-A2-2009/137026**
**WO-A2-2010/140049        US-A1- 2006 010 353**
**US-A1- 2010 106 988      US-A1- 2010 131 109**

**Description**

BACKGROUND OF THE INVENTION

1. Field of the Invention

The present invention relates to a method for managing operation of an information processing system, the system having an information processing device group such as server devices and cooling equipment for cooling the information processing device group. The invention more particularly relates to a method for assigning task loads to an information processing device group. The invention also relates to an information processing system.

2. Description of the Related Art

With the significantly growing number of information processing devices such as server devices, cooling power, i.e., electric power which is consumed by cooling equipment has increased since heat generated by such server devices needs to be cooled. This poses the challenge of systematically reducing cooling power for the cooling equipment and power for the server devices.

For the power-saving within a data center, efforts for reduction in power consumption have been made for information processing devices such as server devices, and cooling equipment and operation management for the information processing devices.

Specifically, the information processing device is devised such that it has improved performance per power consumption by using low-power devices. The information processing device also has employed a power-saving function of switching operation states in response to task loads.

The cooling equipment is devised in a manner to enhance operation efficiency of an air-conditioner incorporated therein and to optimize design for air-flow through an air supply port and a discharge port. The cooling equipment also adopts a system for local cooling or liquid cooling.

For execution of the operation management, operation information is monitored, job scheduling is performed, the efficiencies in operation of a device group are improved by virtualization, and the device group is consolidated.

In general, cooling equipment is designed on the basis of the maximum rating power of all devices in a server device group. Not all the server devices, however, are operated during the actual operation of the cooling equipment, while loads on server devices in operation are not always the highest ones.

With the progress of techniques for managing operation in the data center, when the server devices are consolidated for the purpose of power-saving using a virtualization technique, it is effective to reduce the total power of the cooling equipment in consideration of an uneven power distribution of the device group with respect to the cooling equipment and variations in the power distribution relative to time.

Methods for managing operation of an information processing system with cooling equipment are known in the art as follows.

JP-2004-126968-A discloses that a management server that performs job scheduling for a parallel computer system assigns a new job to a computer with a low temperature on the basis of information received from temperature sensors of computers, moves a job from a computer with a high temperature to a computer with a low temperature, and prevents the parallel computer system from failing and performance degradation due to a high temperature. In addition, JP-2004-126968-A discloses that the management system estimates, on the basis of the temperature information, power consumption for the computers and power consumption for cooling devices provided for the computers before and after the movement of the job and determines whether or not the job can be actually moved.

JP-2007-179437-A discloses that a management system that manages a plurality of computers, extracts information on an overheated computer and a non-overheated computer (computer whose heat radiation is supposed to be low) on the basis of a temperature distribution of the computers and information on operations of the computers, and moves software from the overheated computer to the non-overheated computer so as to save power. In addition, JP-2007-179437-A also discloses that the management system extracts information on target computers which compares a variation in power consumption for the computers before and after the movement of the software with a variation in power consumption for air-conditioners before and after the movement of the software to determine whether or not the software can be moved. JP-2007-179437-A also discloses that the management system which calculates the power consumption for the computers from operation information, calculates the power consumption for the air-conditioners from a temperature distribution, and calculates the temperature distribution from temperature sensors, history records of temperatures and the operation information.

U.S. Patent Application Publication 2006/0259621 discloses that a method for assigning task loads to a plurality of servers arranged in a data center is to compare a profile of a requested task load with a history profile, assign the requested task load to a server in accordance with a history record indicating the minimum total power consumption for the server and an air-conditioner, and randomly assign the task load to any server when the appropriate history record does not exist. U.S. Patent Application Publication 2006/0259621 also discloses that the history profile includes the positions of servers, classes, operation information, temperatures of intake air, temperatures of air to be discharged, the types of task loads, power consumption for the servers and an air-conditioner. U.S. Patent Application Publication 2006/0259621 also discloses that power consumption for the servers and the air-conditioner is calculated from the temperatures of the air taken in the servers, the temperatures of air to be discharged, specific heat and an air volume, or measured by a power meter.

U.S. Patent Application Publication 2006/0259793 discloses that a method for distributing power to a plurality of servers arranged in a data center is to lend and borrow power budgets between servers (or racks) placed physically close to each other so as to cause a temperature distribution or a power distribution to be close to an ideal and analog temperature distribution or power distribution, and is to specify the state of discretized power of the servers on the basis of a budget allocation so as to prevent failure of a server placed at a hot or cold spot. U.S. Patent Application Publication 2006/0259793 also discloses that a heat multiplier factor that indicates ideal power consumption for each of the servers is calculated from the temperature of air discharged from the server, the standard temperature of air discharged from the average server, and the temperature of air taken in an air-conditioner.

Measures to reduce the total power of cooling equipment in consideration of an uneven distribution of power consumed by a device group with respect to the cooling equipment and a variation in the power distribution with respect to time are described in, for example, JP-2011-34578-A. JP-2011-34578-A discloses that an air-conditioner operation coefficient relating to an information processing device is calculated for an air-conditioner and a devicerelated consumption power formula is created for the information processing device. JP-2011-34578-A also discloses that assignment of task loads is determined by using a power-saving evaluation index based on the device-related consumption power formula created for the information processing device so as to achieve saving of power in a whole computer room. In addition, JP-2011-34578-A also discloses that the load of a task operated by the information processing device is controlled on the basis of the result of the assignment of the task loads, power consumption for the air conditioner is calculated on the basis of the air-conditioner operation coefficient and a measured value of power consumption for the information processing device, and output of the air-conditioner is controlled.

## SUMMARY OF THE INVENTION

In JP-2004-126968-A, a job is assigned to a computer that is included in the parallel computer system and has a low temperature, but power is not necessarily saved by the job assignment. Power consumption for the computers before and after the movement of the job is estimated. Although power that is related to the computers from and to which the job is moved is reduced, it turns out to be just local power saving for the whole parallel computer. Therefore, the job movement does not bring comprehensive power saving of a computer room. In JP-2007-179437-A, a variation in power consumption for the computers before and after a movement of software is compared with a variation in power consumption for the air-conditioner before and after the movement of the software. The computers to be compared, however, are limited to extracted overheated and non-overheated computers. The total power consumption for the computer group and the air-conditioner is not taken into account. The technique described in JP-2007-179437-A does not bring comprehensive power saving of a computer room. In U.S. Patent Application Publication 2006/0259621, a task load is assigned to a server on the basis of the history profile indicating the minimum total power consumption for the server and the air-conditioner. Thus, power consumption for the server group and the air-conditioner can be reduced for a task load indicated within the history profile. When there is no history record, the history profile is just sequentially improved in response to accumulation of history records. Thus, it takes a long time to achieve power saving in a computer room. In U.S. Patent Application Publication 2006/0259793, power budgets are lent and borrowed between servers placed close to each other so as to bring the temperature distribution to be close to the ideal temperature distribution. Thus, the total power consumption for the whole server group is not necessarily reduced. This technique, therefore, does not bring power saving in a computer room. The aforementioned conventional techniques only achieve local power saving.

According to JP-2011-34578-A, power saving can be achieved in a computer room by optimizing the assignment of task loads to the information processing device. It, however, takes a long time to calculate the power saving evaluation index. A server for calculating the power saving evaluation index needs to be prepared separately from the servers that execute the original processes.

An object of the invention is to easily assign task loads to information processing devices.

In order to accomplish the aforementioned object, a configuration described in Claims 1 and 2 is used.

In the machine room in the data center including a plurality of servers cooled by heat radiation, in a room isolated from an outdoor space, that allows air to be taken into and discharged from the room, an objective of an air conditioner for cooling is to reduce the temperature (increased due to heat generated by the servers operating in the machine room) of air existing in the machine room so as to reduce the temperatures of air to be taken in the servers to values that are lower than the maximum allowable value. This means that the maximum value among the temperatures of air to be taken in the servers is lower than the maximum allowable value.

It can be said that as the maximum change rate Ai-max (described later with reference to Equation 2) among rates of changes (caused by a change in a load of a certain server) in the temperatures of air taken in the plurality of servers increases, the temperatures of air taken in the servers other than the certain server are more easily increased. When processes with different amounts of loads are to be performed, and a process with the highest load is assigned to an i-th server having the smallest change rate among the maximum change rates Ai-max, the highest temperature among the temperatures of air taken in the plurality of servers becomes lowest among patterns of assignment of the processes. Thus, cooling power requested for the air conditioner is lowest, and whereby power saving can be achieved.

The order of assignment of loads is necessary. Detailed values of air conditioning sensitivities Aij are not necessary. When the condition of airflow in the machine room changes, the values of the air conditioning sensitivities Aij also change. The order of the air conditioning sensitivities Aij hardly changes.

Thus, task loads can be easily assigned to the information processing devices in the order of the air conditioning sensitivities Aij.

BRIEF DESCRIPTION OF THE DRAWINGS

Fig. 1A is a diagram illustrating air conditioning sensitivity table that indicates an example of the air conditioning sensitivities of the five servers according to a first embodiment of the invention;

Fig. 1B is a diagram illustrating an example of a table that indicates the maximum change rates of the temperatures of the air taken in the servers according to a first embodiment of the invention;

Fig. 1C is a diagram illustrating an example of the assignment order table that is obtained from the air conditioning sensitivity table according to a first embodiment of the invention;

Fig. 2 is an exemplary flowchart of the load assignment according to the first embodiment of the invention;

Fig. 3 is a diagram illustrating an example of a graph that indicates required cooling power and describing an effect of a second embodiment of the invention;

Fig. 4 is a diagram illustrating a structure that includes server devices and an air conditioner that are arranged in a data center according to the first embodiment of the invention;

Fig. 5 is a block diagram illustrating a hardware functional configuration of an operation management device according to the first embodiment of the invention; and

Fig. 6 is a block diagram illustrating a functional configuration that includes the operation management device and server devices according to the first embodiment of the invention.

DESCRIPTION OF THE PREFERRED EMBODIMENTS

Hereinafter, embodiments of the invention are described with reference to the accompanying drawings.

First Embodiment

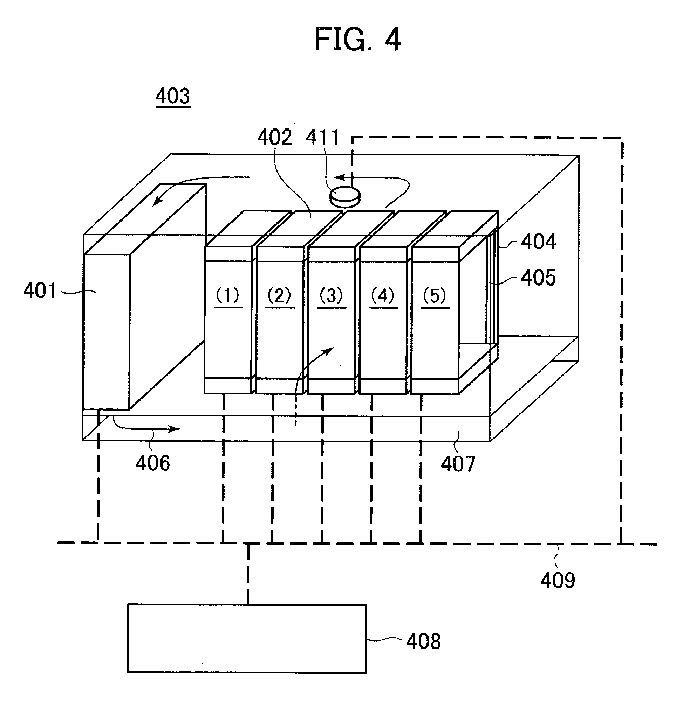

A data center or computer system (hereinafter referred to as data center) according to a first embodiment of the invention is described with reference to the accompanying drawings. Fig. 4 is a diagram illustrating a structure that includes servers, an air conditioner and a temperature sensor that are arranged in the data center according to the present embodiment of the invention. The temperature sensor is arranged on a ceiling surface of the data center.

Referring to Fig. 4, reference numeral 401 indicates the air conditioner. Reference numeral 402 indicates the servers, and reference numeral 403 indicates the data center. Reference numeral 404 indicates a static controller (for example, a capping duct and a capping curtain that are arranged on the discharge side of the servers, or the like). Reference numeral 405 indicates a dynamic controller (for example, a louver arranged on the discharge side of the servers or a porous plate arranged on the discharge side of the servers). Reference numeral 406 indicates air (an arrow illustrated in Fig. 4 indicates the flow of the air). Reference numeral 407 indicates a space located under a floor of the data center. Reference numeral 408 indicates an operation management device. Reference numeral 409 indicates a network. Reference numeral 411 indicates an infrared camera (Since it is sufficient if the infrared camera has a function of monitoring a distribution of temperatures of air intake surfaces of the servers or a function of the temperature sensor, the infrared camera may be replaced with another sensor or a plurality of sensors located at positions at which the temperatures need to be detected).

Fig. 4 illustrates an example of an outline configuration of the data center 403 that includes the five servers 402 and the single air conditioner 401. The servers 402 have therein IT devices, respectively. Examples of each of the IT devices included in the servers 402 are a blade server, a storage device, and a router. The infrared camera 411 is arranged on the ceiling surface of the data center 403. The infrared camera 411 rotates and can thereby monitor (measure) the temperatures of the air intake surfaces (front surfaces of the servers 402 in the example illustrated in Fig. 4) of the five servers 402 in a similar manner to a general monitoring camera. When the infrared camera 411 does not rotate, the infrared camera 411 uses a wide-angle lens and can thereby measure the temperatures of the air intake surfaces of the five servers 402. The static controller 404 (described later) or the dynamic controller 405 (described later) is arranged on air discharge surfaces (back surfaces of the servers 402 in the example illustrated in Fig. 4) of the servers 402.

In the configuration example of the present embodiment, the floor has a double structure. Even when the floor has a normal structure, the same effect can be obtained. The air 406 that is discharged from a bottom portion of the air conditioner 401 passes through the space 407 located under the servers 402 and a ventilator (not illustrated) of the floor and flows into the air intake surfaces (front surfaces) of the servers 402. During the time when the air 406 flows through the IT devices of the servers 402, heat generated from the IT devices is transferred to the air 406. The IT devices of the servers have therein cooling fans (not illustrated), respectively. The built-in cooling fans suck the air 406 from the air intake surfaces of the servers 402. Then, the air 406 causes heat exchange with heat generated from heat generators such as the IT devices of the servers 402. Then, the air 406 is discharged from the air discharge surfaces of the servers 402. In this case, since pressure on the intake side of the servers 402 during the suck by the built-in cooling fans is negative pressure, a part of the discharged air may flow from the discharge side to the intake side.

The air 406 that has passed through the IT devices has a high temperature due to the heat released from the IT devices. The air 406 passes through the air discharge surfaces (back surfaces) of the servers 402, reaches the ceiling surface of the data center 403, and flows into an air intake port of a top portion of the air conditioner 401. Then, the air conditioner 401 uses a refrigerant liquid, cool water or the like to reduce the temperature of the air 406. The air conditioner 401 discharges the air 406 from the bottom portion again. Thus, a circulation structure is formed.

A part of the air 406 that has flowed out of the servers 402 and has a high temperature may return to the air intake surfaces of the servers 402 due to the negative pressure caused by the cooling fans arranged in the IT devices. Especially, the air staying on the upper side of the servers 402 (having the IT devices) strongly tends to return to the side of the air intake surfaces of the servers 402. Thus, the air that stays around the side of the air intake surfaces of the servers 402 has a high temperature. In order to reduce the temperature of the air staying around the side of the air intake surfaces of the servers 402, the temperature of the air to be discharged from the air conditioner 401 is reduced. Thus, power consumption for the air conditioner 401 may be increased. Computation loads or processing loads of the IT devices of the servers 402 vary with respect to time. Thus, the temperature of the air 406 staying around the side of the air discharge surfaces of the servers 402 varies, and whereby the temperature of the air that returns to the side of the air intake surfaces of the servers 402 varies.

In the present embodiment, the infrared camera 411 is arranged on the ceiling surface of the data center 403 and can measure, in real time, the temperatures of the air to be taken in the servers, for example. The temperatures of the air to be taken in the servers vary with respect to time. The static controller 404 (such as the capping duct that is a quadrate and thin plate-like duct forming an air path that guides the air discharged from the servers 402) or the dynamic controller 405 (such as the louver) is adjusted or controlled on the basis of a measured temperature distribution of the air to be taken in the servers 402.

Specifically, in the present invention, the infrared camera 411 measures the temperatures of the air that stays around the front surface side of the servers 402. The temperatures of the intake air supplied to the IT devices of the servers 402 are estimated (or calculated). The static controller 404 or the dynamic controller 405 is controlled so as to adjust the estimated temperatures within a predetermined range. According to the present embodiment, when allowable operating temperature of the IT devices is in a range from 15°C to 35°C, the temperatures of the intake air supplied to the IT devices of all the servers 402 are statically or dynamically controlled so that the controlled temperatures are equalized at any appropriate temperature but lower than 35°C. In this case, not all the IT devices may be arranged on the side of front surfaces of racks. One of the IT devices may be arranged on the side of back surfaces of the racks and another may be in the middle part of the racks. In that case, therefore, the temperatures of the intake air supplied to the IT devices are statically or dynamically controlled in consideration of the temperatures (measured by the infrared camera 411) of the intake air staying around the side of the front surfaces of the racks and the arrangement of the IT devices.

To this end, a controller that estimates (calculates) the temperatures of the intake air supplied to the IT devices included in the racks on the basis of the temperatures (of the air staying around the side of the front surfaces of the racks) measured by the infrared camera 411 is required. Also a control unit that controls the dynamic controller 405 for setting the temperatures of the intake air supplied to the IT devices to be equal to each other is required. The operation management device 408 may be used for such controls, for example. Furthermore, a unit for determining and displaying the size of the capping duct or capping curtain serving as the static controller 404 is also required. For example, the operation management device 408 may determine and display the size of the capping duct or capping curtain.

The temperatures of the intake air supplied to the IT devices can be equalized to each other by controlling the static controller 404 or the dynamic controller 405, and accordingly, the highest temperature of the intake air can be reduced. Consequently, the air conditioner 401 that controls the temperature (or the amount of the air to be discharged from the air conditioner 401) of the air to be discharged from the air conditioner 401, the air conditioner 401 executes the control on the basis of the highest temperature of the intake air. The air conditioner 401 controls to raise the temperature of the air to be discharged from the air conditioner 401 and thereby reducing power consumption for the air conditioner 401.

Locations at which the temperatures of air to be taken in information processing devices and the temperatures of the air discharged from the information processing devices are sensed may be provided for each rack. It is, however, more preferably the locations are provided for each information processing device. Furthermore, sensors may be provided on either the air intake portion or air discharge portion of the information processing devices rather than provided on both portions of the air intake and air discharge portions. In addition, the sensors may be provided for each of groups of the racks rather than provided for each rack. It is preferable that the sensors be arranged close to each other in terms of collecting temperature information for controlling the information processing device and the air conditioner. Even when the sensors are not close to each other, a certain power saving effect can be obtained.

According to the present embodiment, the air flows through the space located under the floor. When the space does not exist under the floor, the cooling air may be discharged from the air conditioner directly to a space in which the information processing devices are arranged. Further, according to the present embodiment, a space between the rack group and the ceiling surface of the data center is used as a path through which the air discharged from the devices flows, a discharged air duct may be provided in the space between the rack group and the ceiling surface or a space located on or above the ceiling surface. In addition, any configuration, or configurations that can be analogized from the present embodiment illustrated in Fig. 4 may be employed. Specifically, the air conditioner may be arranged in a row in which the racks are arranged. A sensor that is provided for the air conditioner and senses the temperature of the air taken in the air conditioner may be built in the air conditioner, while a sensor that is provided for the air conditioner and senses the temperature of the air to be discharged from the air conditioner may be built in the air conditioner. Sensors that sense the temperatures of the air taken in the information processing devices and the temperatures of the air to be discharged from the information processing devices may be built in the information processing devices, respectively.

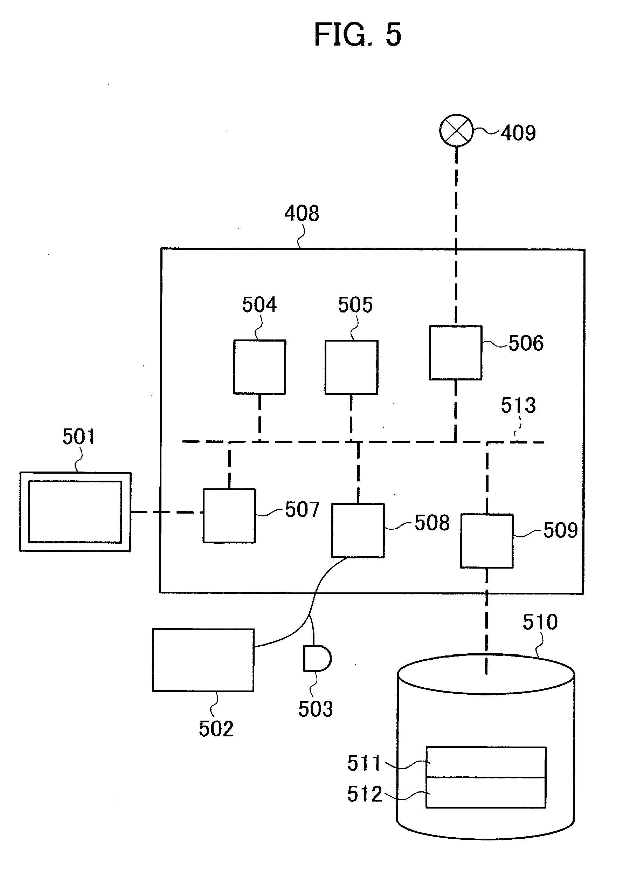

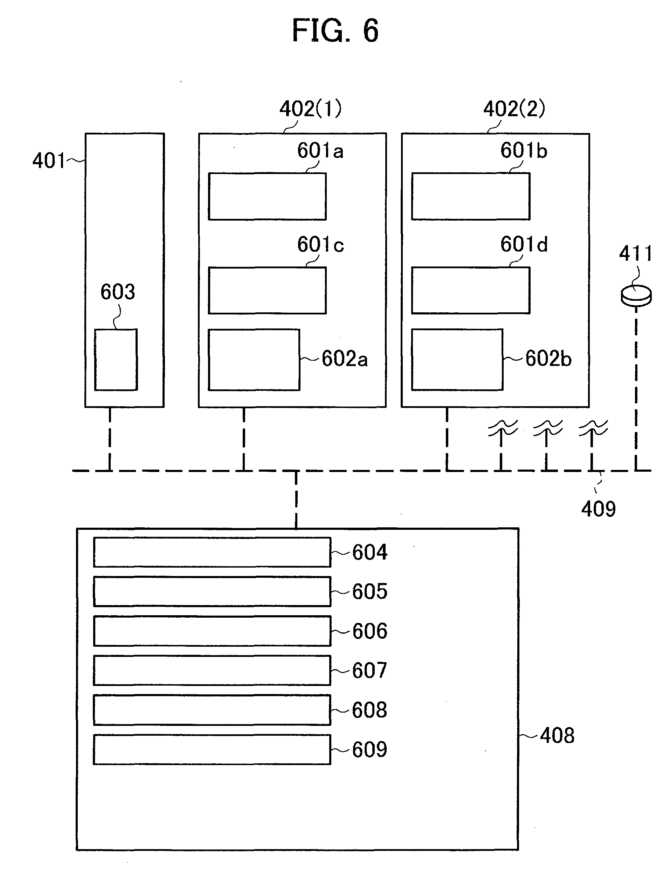

Next, the configuration of the operation management device 408 is described with reference to Figs. 5 and 6. Fig. 5 is a diagram illustrating a hardware configuration of the operation management device 408. Fig. 6 is a diagram illustrating a functional configuration of the operation management device 408.

The hardware of the operation management device 408 is realized by the same configuration as a general personal computer, as illustrated in Fig. 5. The operation management device 408 includes a central processing unit (CPU) 504, a main storage device 505, a network interface 506, a graphic interface 507, an input and output interface 508 and an auxiliary storage device interface 509, which are connected to each other through a bus 513. The CPU 504 controls the parts of the operation management device 408, loads modules for operation management into the later-described main storage device 505 and executes the modules. The main storage device 505 includes a volatile memory such as a RAM and a program to be executed by the CPU 504 and data to be referenced by the CPU 504. The network interface 506 is an interface that is connected to an external network 409. The graphic interface 507 is an interface that is connected to a display device 501 that has a liquid crystal display (LCD) or the like. The input and output interface 508 is an interface that is connected to input and output devices. In the example illustrated in Fig. 5, a keyboard 502 and a mouse 503 that is a pointing device are connected to the input and output interface 508. The auxiliary storage device interface 509 is an interface that is connected to an auxiliary storage device such as a hard disk drive (HDD) 510. The HDD 510 has a large memory capacity and has stored therein a program 511 for operation management and a database 512.

Fig. 6 is a block diagram illustrating the configuration of a system that includes the operation management device 408 according to the first embodiment of the invention and the server devices 402. In the present embodiment, when the information processing devices are the server devices 402, task loads are assigned to the server devices 402 so that power consumption in a whole computer room is saved. In Fig. 6, two server devices 402 that serve as the information processing devices are illustrated, and the remaining three server devices are omitted. The number of server devices 402 is arbitrary. A storage device and a network device may be provided as information processing devices. In the present embodiment, the operation management device 408, the server devices 402 (1) and (2), the air conditioner 401 and the monitoring camera 411 are connected to each other through the network 409. The monitoring camera 411 is the temperature sensor. The air conditioner 401 includes an air management controller 603 that transmits information on the temperature of the air and the like to the server devices 402 (1) and (2) and/or the operation management device 408. The air management controller 603 controls and manages the temperature of the air on the basis of information transmitted by the server devices 402 (1) and (2) and/or the operation management device 408.

When the information processing devices are the server devices 402, task loads 601a to 601d corresponds to OSs executed on virtual machines, or applications of servers such as web servers or database servers. Task load assignment agents 602a and 602b receives instructions from the operation management devices 408 and controls the task loads 601a to 601d on the server devices 402 (1) and (2). The task load assignment agents 602a and 602b may be provided in the server devices 402 (1) and (2), respectively, as illustrated in Fig. 6. The task load assignment agents 602a and 602b may be provided outside the server devices 402 (1) and (2). For example, when the task loads are the OSs executed on the virtual machines, the task load assignment agents 602a and 602b are virtual OS managers and included in the server devices. When the task loads are server applications, the task load assignment agents 602a and 602b are load distribution devices and provided outside the server devices.

The operation management device 408 includes functional elements 604 to 607, a task load assigning element 608 and a task load controller 609. The functional element 604 manages information relating to the information on the temperatures of the air taken in the server devices. The functional element 605 manages information on air conditioning sensitivities of the server devices. The functional element 606 manages information on the maximum change rates of the temperatures of the air taken in the server devices. The functional element 607 manages information included in an assignment order table. These elements may be arranged in the single operation management device 408 as illustrated in Fig. 6 or may be arranged in a plurality of devices.

When the information on the air conditioning sensitivities of the server devices have been already obtained on the basis of the information relating to the information on the temperatures of the air taken in the server devices, and does not need to be changed, the functional element 604 that manages the information relating to the information on the temperatures of the air taken in the server devices may be omitted.

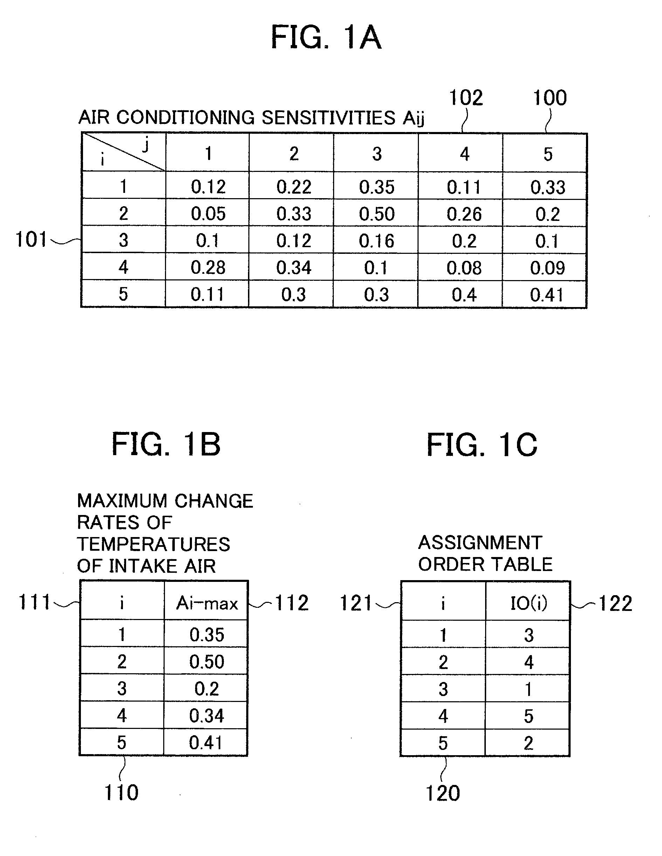

Figs. 1A-1C are diagrams illustrating an example of the order of load assignment according to the present embodiment of the invention. Referring to Fig. 1A, reference numeral 100 indicates a table (hereinafter also referred to as air conditioning sensitivity table) that indicates an example of the air conditioning sensitivities of the five servers according to the present embodiment of the invention.

Reference numeral 101 indicates a row whose index number i is 3, while reference numeral 102 indicates a column whose index number j is 4. As shown in FIG.1B, reference numeral 110 indicates a table that indicates the maximum change rates of the temperatures of the air taken in the servers. The maximum change rates are obtained from the air conditioning sensitivity table 100. Reference numeral 111 indicates a column indicating server numbers i. Reference numeral 112 indicates a column indicating the maximum change rates of the temperatures of the taken air. As shown in FIG.1C, reference numeral 120 indicates an example of the assignment order table that is obtained from the air conditioning sensitivity table 100. Reference numeral 121 indicates a column indicating the order i of assignment, while reference numeral 122 indicates a column indicating server numbers IO(i) of the assignment order table.

In the present embodiment, when a condition of the flowing air does not change in the room, the amount of an increase in the temperature of the air taken in each of the servers is represented by a linear combination of the amounts of heat generated by the server group including the interested server. The number of servers arranged in the room is n.

$$i, \; j = 1, \; 2, \; 3, \; \cdots, \; n \qquad \cdots \; (Equation \; 1)$$

An effect that is given to the temperature of air taken in a j-th server due to a load of an i-th server is represented by an air conditioning sensitivity Aij. When only the i-th server changes its load Wi by an amount $\Delta$Wi, and whereby the temperature of the air taken in the j-th server changes by an amount $\Delta$Tj, the following equation is defined.

$$Aij = \Delta Tj \; / \; \Delta Wi \qquad \cdots \; (Equation \; 2)$$

When the load Wi of the i-th server increases, the maximum change rate Ai-max among change rates of the temperatures of the air taken in the number n of servers is represented by the following equation.

$$Ai\text{-}max = MAX \; (Ai1, \; Ai2, \; \cdots, \; Ain) \quad \cdots \; (Equation \; 3)$$

According to the present invention, when processes are performed for different amounts of loads, processes are assigned to the servers in order from a server having the lowest one of the maximum change rates Ai-max.

Fig. 1A illustrates air conditioning sensitivities calculated from changes in the temperatures of the air taken in the servers j when the five servers are arranged and the load of the third server indicated in the row (indicated by reference numeral 101) whose index number i is 3 is changed.

Specifically, it is assumed that a unit load of each of the servers is defined as an electric power load of 1 kilowatt. In addition, it is assumed that the third server operates with an electric power load of 1 kilowatt, the other servers do not operate, the difference between the temperature of the air taken in the first server and the temperature of the air blown from the air conditioner is 0.1°C, the difference between the temperature of the air taken in the second server and the temperature of the air blown from the air conditioner is 0.12°C, the difference between the temperature of the air taken in the third server and the temperature of the air blown from the air conditioner is 0.16°C, the difference between the temperature of the air taken in the fourth server and the temperature of the air blown from the air conditioner is 0.2°C, and the difference between the temperature of the air taken in the fifth server and the temperature of the air blown from the air conditioner is 0.1°C. Based on the assumption, the aforementioned data is recorded in the row (that is indicated by reference numeral 101 and whose index number i is 3) of the air conditioning sensitivity table 100. In the same manner, for the servers with the server numbers 1 through 5, data is recorded in the other rows of the air conditioning sensitivity table 100. The unit load of each of the servers is defined as an electric power load of 1 kilowatt, but any value other than a value of power as long as the load of the server is proportional to the amount of heat generated by the server may be employed.

Based on the aforementioned assumption, the maximum value among the air conditioning sensitivities of the servers to the load of the third server is 0.2 that is indicated in the column whose index number j is 4. Thus, the maximum change rate Ai-max that is among the change rates of the temperatures of the air taken in the serves and caused by the load of the third server is 0.2.

The maximum change rates Ai-max of the temperatures of the air taken in the servers are obtained in the aforementioned manner and indicated in the table 110. The assignment order table indicated by reference numeral 120 indicates the maximum change rates Ai-max (of the temperatures of the air taken in the servers) arranged in ascending order. The server numbers are indicated in the assignment order table 120. Index numbers i of the assignment order table 120 indicate the order of the maximum change rates Ai-max, while IO(i) of the assignment order table 120 indicate the server numbers. In other words, the index numbers i of the assignment order table 120 indicate the assignment order and form an integer array.

The method for determining the order of the assignment of loads to the five servers is described above as an example. When the same process as described above is performed on more than five servers, the order of the assignment of loads to the servers can be determined. When the number of servers is fixed and the state of airflow in a server room changes, the order of assignment may change. In this case, it is sufficient if the state of the airflow is changed, air conditioning sensitivities are calculated, and the order of the assignment to the servers is recorded for each of the representative states of the airflow.

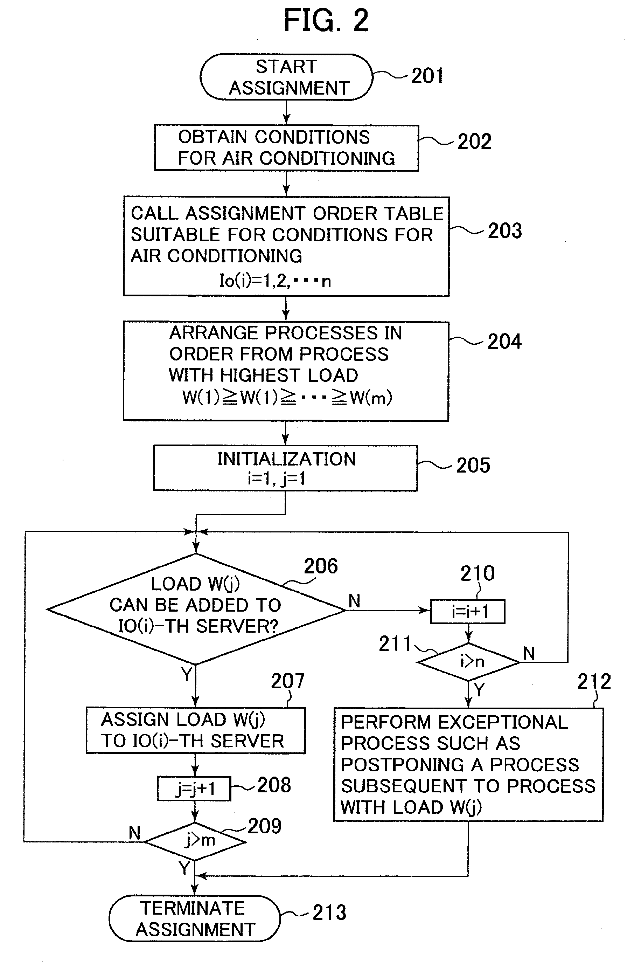

Next, a load assignment process according to the embodiment of the present invention is described with reference to a flowchart of Fig. 2. It is assumed that the number of servers is n and the number of processes to be assigned is m. A unit of each of the processes may be one virtual server or an actual information processing routine. Each of the processes may be assigned only to one server or assigned to a plurality of servers.

In process step S201, the process starts when processes to be assigned and the amounts of loads of the processes to be assigned are known. In process step S202, the number of fans that are operating and of the servers or the like is acquired as a condition for air conditioning. In process step S203, a server assignment table IO(i) suitable for the condition is called out. In process step S204, the processes are arranged in order from a process with the highest load. Process step S204 may not be performed after process steps S202 and S203 and may be performed before process steps S202 and S203. In process step S205, a server number i and a process number j are reset to 1 and a process loop starts.

In process step S206, it is determined whether or not a load W(j) of a process with a number j can be added to a server with a number IO(i). When the load W(j) can be added to the server with the number IO(i) in process step S206, the load W(j) is assigned to the server with the number IO(i) in process step S207. After the assignment, the process number j is incremented by 1 in process step S208. If j > m in process step S209, the load assignment process is terminated. If j ≤ m in process step S209, the load assignment process returns to process step S206. If the load W(j) of the process with the number j cannot be added to the server with the number IO(i) in process step S206, the server number i is incremented by 1 in process step S210. If i > n in step S211, the process cannot be assigned to any of the servers and an exceptional process such as postponing a process subsequent to the process with the load W(j) is performed in process step S212. In process step S213, the load assignment process is terminated.

The processes described with reference to Figs. 1 and 2 do not need machine power which requires a server, and may be performed in the single operation management device 408 that is achieved by the same configuration as a general personal computer. Needless to say, the processes may be distributed to and performed by a plurality of devices. Since the processes do not need machine power which requires a server, the processes almost do not affect the original processes of the servers. Thus, the processes may be performed in the servers in parallel to the original processes of the servers. In this case, the operation management device 408 may be omitted.

Second Embodiment

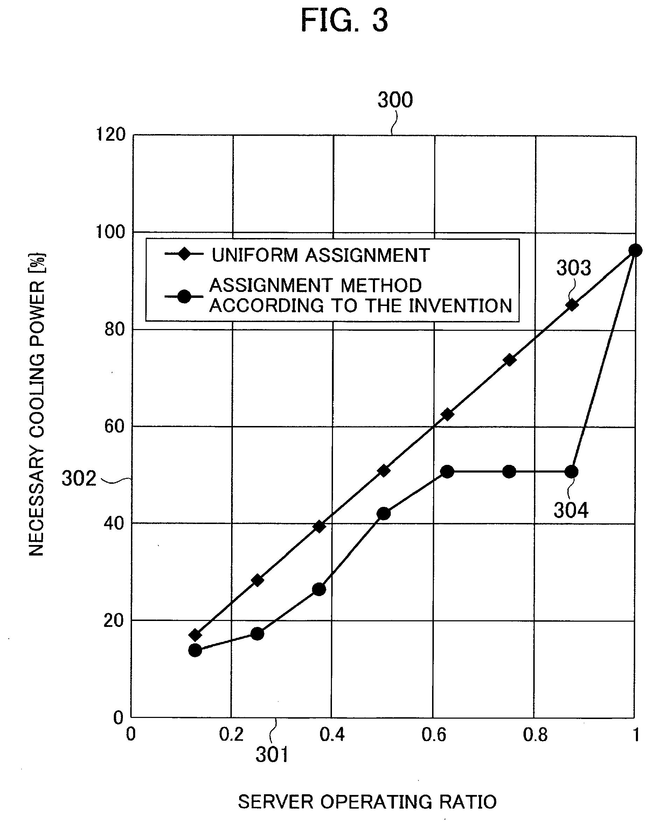

Fig. 3 illustrates an example of a graph indicating required cooling power and an example of an effect of the invention. In Fig. 3, reference numeral 301 denotes the abscissa in the graph and indicates a server operating ratio, while reference numeral 302 denotes the ordinate and indicates required cooling power. Reference numeral 303 indicates the case where loads are uniformly assigned to servers. Reference numeral 304 indicates an example of the load assignment method according to the invention.

In a second embodiment, the graph 300 indicates results that are obtained by measuring required cooling power for an air conditioner through an experiment that has been conducted under the condition that up to eight processes can be assigned to each of the servers and the loads for each process are equalized. The conditions for the experiment simulate a non-steady state in which when the server group is almost fully operating and performing processes, at least one process is reassigned to another server group by maintenance and the like.

The abscissa denoted by reference numeral 301 indicates the server operating ratio, which is 1 when all the servers are fully operating. The ordinate denoted by reference numeral 302 indicates required cooling power, which is required to reduce the highest temperature among the temperatures of air taken in all the servers to a predetermined allowable temperature and is 100% when a setting server operating ratio when all the servers fully operate is 1. When the server operating ratio is 1, the required cooling power is not 100%. This is due to idling for interactions of the servers. Black squares indicated by reference numeral 303 indicate required cooling power when processes are uniformly assigned to the servers, for example, when the operating ratio is 0.125 and a single process is assigned to each of all the servers. On the other hand, required cooling power when processes are assigned using the assignment method according to the invention is represented by black circles indicated by reference numeral 304 and lower than the black squares indicated by reference numeral 303 except when the server operating ratio is 1.

Thus, it is apparent that the load assignment method according to the second embodiment of the invention has a power saving effect even in the non-steady state in which an amount to be processed by a server group is changed.

In this specification, an "air conditioning sensitivity" means a "proportionality coefficient Aij that indicates the amount of an increase in the temperature of air taken in a server (j) when a load (for example, a power to be consumed) of a server (i) increases by a unit amount (for example, an amount of 1 kilowatt). According to the invention, the order of assignment of processes is determined on the basis of sensitivities calculated or measured in advance. Thus, estimation calculation, measurement of the current operation state (load) and temperature measurement do not need to be performed every time a process is assigned. The invention is executable if only loads of processes to be imposed are known. In addition, according to the invention, a power saving effect of minimizing cooling power required of the air conditioner can be achieved.

It may be said that a challenge to be solved by the embodiments is that a load management system for a data center, which determines assignment of task loads such that power saving in a whole computer room is achieved, simplifies a method for calculating a power saving evaluation index, thereby allowing task loads to be assigned to information processing devices with ease.

It is to be noted that the present invention is not limited to the aforementioned embodiments, but covers various modifications. While, for illustrative purposes, those embodiments have been described specifically, the present invention is not necessarily limited to the specific forms disclosed. Thus, partial replacement is possible between the components of a certain embodiment and the components of another. Likewise, certain components can be added to or removed from the embodiments disclosed.

Note also that some or all of the aforementioned components, functions, processors, and the like can be implemented by hardware such as an integrated circuit or the like. Alternatively, those components, functions, and the like can be implemented by software as well. In the latter case, a processor can interpret and execute the programs designed to serve those functions. The programs, associated data tables, files, and the like can be stored on a stationary storage device such as a memory, a hard disk, and a solid state drive (SSD) or on a portable storage medium such as an integrated circuit card (ICC), an SD card, and a DVD.

Further note that the control lines and information lines shown above represent only those lines necessary to illustrate the present invention, not necessarily representing all the lines required in terms of products. Thus, it can be assumed that almost all the components are in fact interconnected.

## Claims

1. A method for determining assignment of loads of a data center, the data center including a plurality of server systems cooled by heat radiation, in a room isolated from an outdoor space, that allows air to be taken into and discharged from the room, wherein

for the assignment of a plurality of processes to each server system, the method comprises the steps of:

obtaining an air conditioning sensitivity table with proportionality coefficients Aij stored in an operation management device and indicating the amount of increase in a temperature of an air intake surface of one server system j arranged in the room in response to an increase in the load on the same or another server system i arranged in the room by a unit amount, and

comparing for each server system i the proportionality coefficients Aij pertaining to the respective server systems j to obtain the maximum proportionality coefficients Ai-maxfor each server system i,

assigning the plurality of processes to the plurality of server systems in an order, wherein a process with the highest load is assigned to the server system with the smallest maximum proportionality coefficient Ai-max.

2. An information processing system comprising:

a plurality of server systems cooled by heat radiation, in a room isolated from an outdoor space, that allows air to be taken into and discharged from the room,; and

an operation management device, wherein

for the assignment of a plurality of processes to each server system, the operation management device is configured to:

obtain an air conditioning sensitivity table with proportionality coefficients Aij stored in the an operation management device and indicating the amount of increase in a temperature of an air intake surface of one server system j arranged in the room in response to an increase in the load on the same or another server system i arranged in the room by a unit amount;

compare for each server system i the proportionality coefficients Aij pertaining to the respective server systems j to obtain the maximum proportionality coefficients Ai-max for each server system i, and

assign the plurality of processes to the plurality of server systems in an order, wherein a process with the highest load is assigned to the server system with the smallest maximum proportionality coefficient Ai-max..

3. The information processing system according to claim 2,

wherein the operation management device comprises an assignment order table in which an integer array IO(i) indicates the server system number of the server system whose assignment order (i), while the assignment order (i) is obtained by arranging the maximum proportionality coefficients (Ai-max) in descending order, and

wherein the operation management device assigns the processes to the server system whose server number is IO(i) in order from a server system having the smallest assignment order (i) and from the process with the highest load.

4. The information processing system according to claim 2,

wherein the operation management device is configured to acquire a condition for air conditioning and to call the assignment order table suitable for the condition.

5. The information processing system according to claim 4,

wherein the condition for air conditioning is the number of fans that are included in the server systems and are operating.

**Patentansprüche**

1. Verfahren zur Bestimmung der Lastzuweisung eines Datenzentrums, wobei das Datenzentrum eine Mehrzahl von Serversystemen aufweist, welche durch Wärmeabstrahlung gekühlt werden, und sich in einem vom Außenraum isolierten Raum befinden, welcher das Zuführen und Ablassen von Luft zum und aus diesem Raum zulässt, wobei das Verfahren für die Zuordnung einer Mehrzahl von Prozessen zu jedem Serversystem die folgenden Schritte umfasst:

das Erstellen einer Klimatisierungs-Empfindlichkeitstabelle, wobei die Proportionalitätskoeffizienten Aij in einer Betriebsverwaltungseinrichtung gespeichert sind und die Höhe des Temperaturanstiegs einer Luftansaugfläche eines im Raum angeordneten Serversystems j in Reaktion auf den Anstieg der Last desselben oder eines anderen im Raum angeordneten Serversystems i um einen Einheitsbetrag anzeigen, und

für jedes Serversystem i das Vergleichen der Proportionalitätskoeffizienten Aij, welche zu den jeweiligen Serversystemen j gehören, um die maximalen Proportionalitätskoeffizienten Ai-max für jedes Serversystem i zu erhalten,

die Zuordnung der Mehrzahl der Prozesse zu der Mehrzahl der Serversysteme in einer Reihenfolge, bei der ein Prozess mit der höchsten Last demjenigen Serversystem mit dem geringsten maximalen Proportionalitätskoeffizienten Ai-max zugeordnet ist.

2. Ein Informationsverarbeitungssystem, welches folgendes aufweist:

eine Mehrzahl von Serversystemen, welche durch Wärmeabstrahlung gekühlt werden, in einem vom Außenraum isolierten Raum, welcher das Zuführen und Ablassen von Luft zum und aus diesem Raum zulässt; und
eine Betriebsverwaltungseinrichtung, wobei
für die Zuordnung einer Mehrzahl von Prozessen zu jedem Serversystem die Betriebsverwaltungseinrichtung derart konfiguriert ist, dass sie:
eine Klimatisierungs-Empfindlichkeitstabelle erstellt, wobei die Proportionalitätskoeffizienten Aij in der Betriebsverwaltungseinrichtung gespeichert sind, und die Höhe des Temperaturanstiegs einer Luftansaugfläche eines im Raum angeordneten Serversystems j in Reaktion auf den Anstieg der Last desselben oder eines anderen im Raum angeordneten Serversystems i um einen Einheitsbetrag angezeigt wird;
für jedes Serversystem i die Proportionalitätskoeffizienten Aij vergleicht, welche zu den jeweiligen Serversystemen j gehören, um die maximalen Proportionalitätskoeffizienten Ai-max für jedes Serversystem i zu erhalten, und
die Mehrzahl der Prozesse zu der Mehrzahl der Serversysteme in einer Reihenfolge zuordnet, bei der ein Prozess mit der höchsten Last demjenigen Serversystem mit dem geringsten maximalen Proportionalitätskoeffizienten Ai-max. zugeordnet ist.

3. Das Informationsverarbeitungssystem nach Anspruch 2,
wobei die Betriebsverwaltungseinrichtung eine Tabelle mit der Zuordnungsreihenfolge aufweist, in welcher ein Integer-Array IO (i) die Serversystemnummer des Serversystems anzeigt, dessen Zuordnungsreihenfolge (i), wobei die Zuordnungsreihenfolge (i) ermittelt wird durch Anordnung der maximalen Proportionalitätskoeffizienten (Ai-max) in absteigender Reihenfolge, und
wobei die Betriebsverwaltungseinrichtung die Prozesse demjenigen Serversystem zuordnet, dessen Servernummer IO (i) ist in der Reihenfolge beginnend mit dem Serversystem mit der kleinsten Zuordnungsreihenfolge (i) und dem Prozess mit der höchsten Last.

4. Das Informationsverarbeitungssystem nach Anspruch 2, wobei die Betriebsverwaltungseinrichtung so konfiguriert ist, dass sie eine Bedingung für die Klimatisierung ermittelt und passend für diese Bedingung die Tabelle mit der Zuordnungsreihenfolge aufruft.

5. Das Informationsverarbeitungssystem nach Anspruch 4, wobei die Bedingung für die Klimatisierung der Anzahl der Ventilatoren entspricht, die in den Serversystemen enthalten und in Betrieb sind.

## Revendications

1. Procédé de détermination d'une attribution de charges d'un centre de données, le centre de données incluant une pluralité de systèmes de serveurs refroidis par un rayonnement thermique, dans une salle isolée d'un espace extérieur, qui permet que de l'air soit admis dans et évacué de la salle, dans lequel
pour l'attribution d'une pluralité de processus à chaque système de serveurs, le procédé comprend les étapes de :

obtention d'une table de sensibilité à la climatisation avec des coefficients de proportionnalité Aij stockés dans un dispositif de gestion des opérations et indiquant la quantité d'augmentation d'une température d'une surface d'entrée d'air d'un système j de serveurs agencé dans la salle en réponse à une augmentation de la charge sur ce système de serveurs ou un autre i agencé dans la salle d'une quantité unitaire, et
comparaison pour chaque système i de serveurs des coefficients de proportionnalité Aij se rapportant aux systèmes j de serveurs respectifs pour obtenir les coefficients de proportionnalité maximum Ai-max pour chaque système i de serveurs,
attribution de la pluralité de processus à la pluralité de systèmes de serveurs dans un certain ordre, dans lequel un processus avec la charge la plus élevée est attribué au système de serveurs avec le coefficient de proportionnalité maximum Ai-max le plus petit.

2. Système de traitement d'informations comprenant :

une pluralité de systèmes de serveurs refroidis par un rayonnement thermique, dans une salle isolée d'un espace extérieur, qui permet que de l'air soit admis dans et évacué de la salle ; et
un dispositif de gestion des opérations, dans lequel
pour l'attribution d'une pluralité de processus à chaque système de serveurs, le dispositif de gestion des opérations est configuré pour :
obtenir une table de sensibilité à la climatisation avec des coefficients de proportionnalité Aij stockés dans le dispositif de gestion des opérations et indiquant la quantité d'augmentation d'une température d'une surface d'entrée d'air d'un système j de serveurs agencé dans la salle en réponse à une augmentation de la charge sur ce système de serveurs ou un autre i agencé dans la salle d'une quantité unitaire ;
comparer pour chaque système i de serveurs les coefficients de proportionnalité Aij se rapportant aux systèmes j de serveurs respectifs pour obtenir les coefficients de proportionnalité maximum Ai-max pour chaque système i de serveurs, et
attribuer la pluralité de processus à la pluralité de systèmes de serveurs dans un certain ordre, dans lequel un processus avec la charge la plus élevée est attribué au système de serveurs avec le coefficient de proportionnalité maximum Ai-max le plus petit.

3. Système de traitement d'informations selon la revendication 2,
dans lequel le dispositif de gestion des opérations comprend une table d'ordre d'attribution dans laquelle une matrice d'entiers IO(i) indique le numéro de système de serveurs du système de serveurs dont l'ordre d'attribution est (i), tandis que l'ordre d'attribution (i) est obtenu en agençant les coefficients de proportionnalité maximum (Ai-max) en ordre décroissant, et
dans lequel le dispositif de gestion des opérations attribue les processus au système de serveurs dont le numéro de serveur est IO(i) dans l'ordre à partir d'un système de serveurs ayant l'ordre d'attribution (i) le plus petit et à partir du processus avec la charge la plus élevée.

4. Système de traitement d'informations selon la revendication 2,
dans lequel le dispositif de gestion des opérations est configuré pour acquérir une condition pour une climatisation et pour appeler la table d'ordre d'attribution appropriée à la condition.

5. Système de traitement d'informations selon la revendication 4,
dans lequel la condition pour une climatisation est le nombre de ventilateurs qui sont inclus dans les systèmes de serveurs et qui fonctionnent.

# FIG. 1A

AIR CONDITIONING SENSITIVITIES Aij

| i \ j | 1 | 2 | 3 | 4 | 5 |
|---|---|---|---|---|---|
| 1 | 0.12 | 0.22 | 0.35 | 0.11 | 0.33 |
| 2 | 0.05 | 0.33 | 0.50 | 0.26 | 0.2 |
| 3 | 0.1 | 0.12 | 0.16 | 0.2 | 0.1 |
| 4 | 0.28 | 0.34 | 0.1 | 0.08 | 0.09 |
| 5 | 0.11 | 0.3 | 0.3 | 0.4 | 0.41 |

# FIG. 1B

MAXIMUM CHANGE RATES OF TEMPERATURES OF INTAKE AIR

| i | Ai-max |
|---|---|
| 1 | 0.35 |
| 2 | 0.50 |
| 3 | 0.2 |
| 4 | 0.34 |
| 5 | 0.41 |

# FIG. 1C

ASSIGNMENT ORDER TABLE

| i | IO(i) |
|---|---|
| 1 | 3 |
| 2 | 4 |
| 3 | 1 |
| 4 | 5 |
| 5 | 2 |

# FIG. 2

START ASSIGNMENT — 201

OBTAIN CONDITIONS FOR AIR CONDITIONING — 202

CALL ASSIGNMENT ORDER TABLE SUITABLE FOR CONDITIONS FOR AIR CONDITIONING
$Io(i)=1,2,\cdots n$ — 203

ARRANGE PROCESSES IN ORDER FROM PROCESS WITH HIGHEST LOAD
$W(1) \geqq W(1) \geqq \cdots \geqq W(m)$ — 204

INITIALIZATION
$i=1, j=1$ — 205

LOAD $W(j)$ CAN BE ADDED TO $IO(i)$-TH SERVER? — 206

N → $i=i+1$ — 210

$i>n$ — 211

Y

ASSIGN LOAD $W(j)$ TO $IO(i)$-TH SERVER — 207

$j=j+1$ — 208

$j>m$ — 209

N

PERFORM EXCEPTIONAL PROCESS SUCH AS POSTPONING A PROCESS SUBSEQUENT TO PROCESS WITH LOAD $W(j)$ — 212

Y

TERMINATE ASSIGNMENT — 213

# FIG. 3

# FIG. 4

EP 2 575 003 B1

# FIG. 5

17

# FIG. 6

**EP 2 575 003 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004126968 A
- JP 2007179437 A
- US 20060259621 A
- US 20060259793 A
- JP 2011034578 A